# EUROPEAN PATENT APPLICATION

(11) **EP 1 864 784 A1**
(43) Date of publication of application: **12.12.2007**
(21) Application number: 06730656.3
(22) Date of filing: 30.03.2006
(51) Int. Cl.: B29C 65/14, C12M 1/00, C12N 15/09

(54) **METHOD FOR BONDING SUBSTRATES, METHOD FOR FORMING CHIP, AND CHIP**

(30) Priority: 31.03.2005 JP 2005101076
(71) Applicant: ROHM CO., LTD., Kyoto-shi, Kyoto 615-8585 (JP)
(72) Inventor: SHIMASAKI, Takaaki c/o ROHM CO., LTD, Kyoto-shi Kyoto 6158585 (JP)
(74) Representative: Skuhra, Udo
(86) International application number: PCT/JP2006/306708
(87) International publication number: WO 2006/106848

(57) **Abstract**

It is an object of the present invention to provide a method for bonding substrates, with which substrates can be bonded together without being damaged. There is provided a method for bonding a first substrate 10 and a second substrate 20, comprising the steps of forming the main body of at least one of the first substrate 10 and the second substrate 20 from an optically transmissive material that transmits light, forming at least part of the bonding faces of the first substrate 10 and the second substrate 20 from a thermoplastic resin that contains an optical absorption agent 23 that absorbs light, and bonding the first substrate 10 and the second substrate 20 together by irradiating the optical absorption agent 23 of the bonding faces with light via the substrate that transmits light.

## Description

### TECHNICAL FIELD

This invention relates to a method for bonding substrates, to a chip formation method, and to a chip.

### BACKGROUND ART

There is increasing demand for the detection and quantification of DNA (deoxyribonucleic acid), enzymes, proteins, antigens, antibodies, viruses, cells, and other such biological and chemical substances in the fields of medicine, health, foods, pharmaceuticals, and so on. Various kinds of bio-chips and micro chemical chips have been proposed which allow these substances to be measured with ease. A feature of these chips is that they allow a reaction to be concluded in a short time by introducing a tiny amount of sample or specimen into a channel that is only a few hundred microns in width. These chips are produced by bonding two substrates together, and technology for the bonding of the substrates is particularly important. A hot melt adhesive, UV (ultraviolet) adhesive, or other such adhesive agent is used, for example, to bond substrates together.

A hot melt adhesive is a linear, macromolecular copolymer whose main component is an ethylene vinyl acetate copolymer (EVA). EVA softens at 80 to 110°, and becomes fluid enough for adhesion between 160 and 180°. Thus, substrates can be bonded together by coating the bonding faces of the substrates with a hot melt adhesive that has been heated and melted at about 180°, and then cooling.

A UV adhesive contains a photopolymerization initiator, an acrylic oligomer, and an acrylic monomer or the like, and is an adhesive in which the polymers that make up the UV adhesive undergoes the radical polymerization under irradiation with UV light. The bonding faces of two substrates are coated with the UV adhesive and then heated to between 40 and 80° while being irradiated from outside the substrate with UV light having a wavelength of 150 to 410 nm. The substrates are bonded together here by the formation of a polymer in the polymerization of the acrylic oligomer and the acrylic monomer by radicals generated from the photopolymerization initiator.

Ultrasonic welding has also been studied, in which a first substrate and a second substrate are bonded together by disposing them facing each other and pressing while applying ultrasonic waves.

When a hot melt adhesive, UV adhesive, or other such adhesive agent is used, however, the molten adhesive can flow into the channel, a reagent reservoir, or the like and destroy the pattern, which impedes the flow of the fluid through the channel. An adhesive that flows into the channel also prevents the reaction of the biological or chemical substance. In particular, with a method in which a hot melt adhesive is used, the adhesive is used after being heated to about 160 to 180°, so the entire substrate coated with the adhesive also becomes hot. This destroys the pattern of the channel, reagent reservoir, or the like formed on the substrate. Furthermore, when the biological or chemical substance is fixed to the channel, reagent reservoir, or the like, the substrate can become so hot that the substance is deactivated. Also, with ultrasonic welding, the pressing of the first substrate and second substrate may result in destruction or strain in the channel, etc., in the substrate, or even in the substrate itself.

### SUMMARY OF THE INVENTION

In view of this, it is an object of the present invention to provide a bonding method with which substrates can be bonded together without being damaged.

In order to solve the above described problems, a first aspect of the present invention provides a method for bonding a first substrate and a second substrate, comprising the steps of forming the main body of at least one of the first substrate and the second substrate from an optically transmissive material that transmits light, forming at least part of the bonding faces of the first substrate and the second substrate from a thermoplastic resin that contains an optically absorbent substance that absorbs light, and bonding the first substrate and the second substrate together by irradiating the optically absorbent substance of the bonding faces with light via the substrate that transmits light.

For example, when the first substrate is formed from an optically transmissive material that transmits light, the first substrate and second substrate are brought into contact and irradiated with light from the top of the first substrate. This light is transmitted by the first substrate and reaches the optically absorbent substance formed on at least part of the bonding faces of the first substrate and second substrate. When the optically absorbent substance absorbs light, the thermoplastic resin containing the optically absorbent substance is heated and melts. The molten thermoplastic resin is cooled and then cured to bond the first substrate and second substrate together.

With this bonding method, there is no need to use an adhesive agent in the bonding of the substrates. Thus, damage to the substrates, such as deformation of the pattern in the substrate, or obstruction of the flow of fluid within the channel by outflow of the adhesive agent can be prevented.

Also, when the light transmitted through a substrate is absorbed by the optically absorbent substance located on the bonding faces, the bonding faces generate heat locally. In other words, heat is not applied to the entire first substrate and second substrate, and instead the locally generated heat melts the thermoplastic resin at the bonding faces and bonds the substrates together. This prevents the destruction or deformation of the entire substrates by heat. Also, in this bonding, if a detection substance, such as a biological substance, has already been disposed within the substrates, deactivation of the detection substance by the heat generated from the entire substrates can be prevented. Furthermore, the side walls of the channel, etc., within the substrates can be prevented from melting and impeding the reaction of the detection substance.

Also, since there is no need for the substrates to be pressed tightly together at the time of their bonding, this method prevents the pattern of the channel, the reagent reservoir, etc., formed in the substrates from being destroyed or deformed by tight pressing. Destruction or deformation of the substrates themselves by tight pressing can also be prevented.

A second aspect of the present invention provides a method for bonding according to the first aspect of the present invention, wherein a detection substance for detecting a substance to be measured is disposed on the first substrate and/or the second substrate, and the wavelength of the light is between 400 nm and 2.5 µm.

Examples of the substance to be measured include glucose or cholesterol in blood. The detection substance is a substance that will react with the substance to be measured, and can be an enzyme, protein, antigen, antibody, bacteria, yeast, micro-organism, or other such biological substance, a chemical substance, or the like. Here, since UV light and other such short-wavelength light has high energy, there is the danger that the light will break the covalent bonds of the detection substance and deactivate it. However, since the energy of light with a wavelength between 400 nm and 2.5 µm is not more than the bond dissociation energy of the detection substance, deactivation of the detection substance can be prevented.

A third aspect of the present invention provides a method for bonding according to the first aspect of the present invention, wherein a mask for blocking the light is disposed on a portion corresponding to a place on the first substrate and/or second substrate where the detection substance is fixed, or to a place on the first substrate and/or second substrate where a pattern is formed, and the optically absorbent substance on the bonding faces is irradiated with light from above the mask.

Light can be prevented from irradiating the detection substance or the pattern of channel, etc., by directing the light from above a mask disposed corresponding to the detection substance or the pattern in the substrates. Thus, deactivation of the detection substance by heat or deformation of the channel by heat can be prevented.

A fourth aspect of the present invention provides a method for bonding according to the third aspect of the present invention, wherein the first substrate and the second substrate are thermoplastic resin substrates, and the melting points of the first substrate and the second substrate are substantially the same.

Of the two substrates, the first substrate, for example, is formed by a thermoplastic resin substrate made of an optically transmissive material. The second substrate is formed by a thermoplastic resin substrate that includes an optically absorbent substance at the bonding face with the first substrate. Here, if the first substrate and second substrate are formed by thermoplastic resin substrates with substantially the same melting points, then the bonding faces of the first substrate and second substrate will melt at substantially the same time when the optically absorbent substance is irradiated with light, making it easier to bond the substrates together.

A fifth aspect of the present invention provides a method for forming a chip which is formed by bonding a first substrate and a second substrate, said method comprising the steps of forming the main body of at least one of the first substrate and the second substrate from an optically transmissive material that transmits light, forming at least part of the bonding faces of the first substrate and the second substrate from a thermoplastic resin that contains an optically absorbent substance that absorbs light, forming a channel in a main face of the first substrate and/or the second substrate, and bonding the first substrate and the second substrate together by positioning the first substrate and the second substrate across from each other so as to cover the channel, and irradiating the optically absorbent substance of the bonding faces with light via the substrate that transmits light.

This chip formation method has the same effects as the first aspect of this invention.

A sixth aspect of the present invention provides a method for forming a chip according to the fifth aspect of the present invention, wherein carbon black is used as the optically absorbent substance, and the layer containing the carbon black has a carbon black content of at least 0.01 vol% and not more than 0.025 vol%.

Setting the carbon black content to at least 0.01 vol% and not more than 0.025 vol% allows the elution of carbon black into the solution to be suppressed. Thus, a biochemical reaction can be conducted properly in the solution in the channel formed within the chip, and the sample or the like can be accurately quantified. Also, if the content is within this range, sufficient bonding strength can be ensured between the substrates, without any color unevenness occurring in the substrate. Thus, setting the carbon black content to be within the above-mentioned range allows efficient use of the carbon black while fully exploiting the characteristics of the carbon black.

A seventh aspect of the present invention provides a method for forming a chip according to the sixth aspect of the present invention, wherein the layer containing the carbon black is formed by injection molding.

Injection molding is a simple manufacturing method that is routinely used to form substrates, being able to use injection molding at the above content affords better productivity and production cost for substrates containing carbon black.

A eighth aspect of the present invention provides a method for forming a chip according to the fifth aspect of the present invention, wherein, in the step of bonding the first substrate and the second substrate, the first substrate and the second substrate are bonded together by subjecting a main face of at least one of the first substrate and the second substrate other than the bonding faces to pressure from a transparent glass sheet via a transparent plate having an irregular surface.

The first substrate and/or second substrate can be prevented from sticking to the transparent glass sheet by interposing a transparent plate having an irregular surface in between the first substrate and/or second substrate and the transparent glass sheet, as discussed above.

A ninth aspect of the present invention provides a method for forming a chip according to the eighth aspect of the present invention, wherein the main face other than the bonding faces that comes into contact with the transparent plate is treated with a solvent.

This solvent treatment is performed as a surface modification, surface coating, or other such surface treatment, or to clean or sterilize the surface. When a solvent treatment is performed, the main face other than the bonding faces is sometimes treated so that it will have elasticity. The first substrate and/or second substrate can be prevented from sticking to the transparent glass sheet by interposing a transparent plate having an irregular surface in between the first substrate and/or second substrate and the transparent glass sheet.

A tenth aspect of the present invention provides a method for forming a chip according to the fifth aspect of the present invention, wherein, in the step of bonding the first substrate and the second substrate, the first substrate and the second substrate are bonded together by subjecting a main face of at least one of the first substrate and the second substrate other than the bonding faces to pressure from a transparent glass sheet, and a transparent resin film is formed on a main face of the transparent glass sheet in contact with the main face other than the bonding faces. Using the transparent resin film in this invention has the same effects as the eighth invention.

A eleventh aspect of the present invention provides a method for forming a chip according to the fifth aspect of the present invention, wherein the main face other than the bonding faces in contact with the transparent resin film of the transparent glass sheet is treated with a solvent. Using the constitution of this invention has the same effect as the ninth invention.

A twelfth aspect of the present invention provides a chip, including a first substrate formed from a thermoplastic resin, a second substrate opposed and bonded to the first substrate, and a channel formed on a main face of the first substrate and/or the second substrate, wherein the main body of at least one of the first substrate and the second substrate is an optically transmissive material that transmits light, at least part of the bonding faces of the first substrate and the second substrate include an optically absorbent substance that absorbs light, and the bonding face of the first substrate or the second substrate, which are across from each other so as to cover the channel, are bonded together by irradiating the optically absorbent substance of the bonding faces with light via the substrate that transmits light.

A chip formed in this way has the same effects as the first aspect of this invention.

A thirteenth aspect of the present invention provides a chip according to the twelfth aspect of the present invention, wherein a detection substance for detecting a substance to be measured is fixed in the channel.

Examples of the substance to be measured include glucose or cholesterol in blood. The detection substance is a substance that will react with the substance to be measured, and can be an enzyme, protein, antigen, antibody, bacteria, yeast, micro-organism, or other such biological substance, a chemical substance, or the like. Fixing the detection substance in the channel allows the substance to be measured, which reacts with the detection substance, to be detected from the solution that has passed through the channel.

Here, with the bonding method of this invention, since the substrates are bonded together by locally generating heat at bonding faces including an optically absorbent substance, heat is not applied to the overall substrate during chip formation. Deactivation of the detection substance fixed to the channel can thus be prevented.

A fourteenth aspect of the present invention provides a chip according to the thirteenth aspect of the present invention, wherein the detection substance is fixed at least 100 µm away from the location where the optically absorbent substance is introduced.

The optically absorbent substance generates heat upon absorbing the irradiating light. Deactivation of the detection substance by heat generated during substrate bonding can be prevented by disposing the detection substance a predetermined distance away from the optically absorbent substance.

A fifteenth aspect of the present invention provides a chip according to the twelfth aspect of the present invention, wherein the optically absorbent substance is a colorant.

An example of this colorant is carbon black.

A sixteenth aspect of the present invention provides a method for bonding according to the twelfth aspect of the present invention,

A sixteenth aspect of the present invention provides a chip according to the twelfth aspect of the present invention, wherein the optically absorbent substance is a colorant having a different color for each substance to be measured.

Examples of the substance to be measured include glucose and cholesterol. Thus, the user can easily confirm the chip to be used for measurement by using colorants of different colors for each substance to be measured. This prevents the user from accidentally picking up the wrong chip during measurement.

A seventeenth aspect of the present invention provides a chip according to the twelfth aspect of the present invention, wherein carbon black is used as the optically absorbent substance, and a layer containing the carbon black has a carbon black content of at least 0.01 vol% and not more than 0.025 vol%.

Setting the carbon black content to at least 0.01 vol% and not more than 0.025 vol% allows the elution of carbon black into the solution to be suppressed. Thus, a biochemical reaction can be conducted properly in the solution in the channel formed within the chip, and the sample or the like can be accurately quantified. Also, if the content is within this range, sufficient bonding strength can be ensured between the substrates, without any color unevenness occurring in the substrate. Thus, setting the carbon black content to be within the above-mentioned range allows efficient use of the carbon black while fully exploiting the characteristics of the carbon black.

A eighteenth aspect of the present invention provides a chip according to the seventeenth aspect of the present invention, wherein the layer containing the carbon black is formed by injection molding.

Injection molding is a simple manufacturing method that is routinely used to form substrates, so being able to use injection molding at the above content affords better productivity and production cost for substrates containing carbon black.

With the present invention, there is no need to use an adhesive agent to bond substrates together. Thus, damage to the substrates, such as deformation of the pattern in the substrate by outflow of the adhesive agent, can be prevented, and the flow of a fluid through the channel will not be impeded.

### Brief Description of Drawings

FIG. 1A is a plan view of the chip according to a first embodiment of the present invention;
FIG. 1B is a cross-sectional view along the A-A' line in FIG. 1A;
FIG. 2A is a cross-sectional view (1) illustrating a method for bonding a first thermoplastic resin substrate 10 and a second thermoplastic resin substrate 20;
FIG. 2B is a cross-sectional view (2) illustrating a method for bonding the first thermoplastic resin substrate 10 and the second thermoplastic resin substrate 20;
FIG. 3 is a cross-sectional view illustrating a method for bonding substrates by partial irradiation using a mask;
FIG. 4 is a cross-sectional view of a chip in which a detection substance is fixed to the surface of the second thermoplastic resin substrate;
FIG. 5A is a cross-sectional view (1) illustrating a method for bonding a chip according to the first embodiment of the present invention;
FIG. 5B is a cross-sectional view (2) illustrating a method for bonding a chip according to the first embodiment of the present invention;
FIG. 6A is a plan view of a chip according to a second embodiment of the present invention;
FIG. 6B is a cross-sectional view along the B-B' line in FIG. 6A;
FIG. 6C is a cross-sectional view illustrating a method for forming an optical absorption layer;
FIG. 7A is a cross-sectional view of a substrate having a partial optical absorption layer;
FIG. 7B is a cross-sectional view illustrating a method for forming a partial optical absorption layer 28;
FIG. 8A is a cross-sectional view (1) illustrating a method for bonding a chip according to the second embodiment of the present invention;
FIG. 8B is a cross-sectional view (2) illustrating a method for bonding a chip according to the second embodiment of the present invention;
FIG. 9A is a plan view of a chip according to a third embodiment of the present invention;
FIG. 9B is a cross-sectional view along the C-C' line in FIG. 9A;
FIG. 10A is a cross-sectional view (1) illustrating a method for bonding a bio-chip 180 shown in FIG. 9,
FIG. 10B is a cross-sectional view (2) illustrating a method for bonding the bio-chip 180 shown in FIG. 9;
FIG. 10C is a cross-sectional view (3) illustrating a method for bonding the bio-chip 180 shown in FIG. 9;
FIG. 10D is a cross-sectional view (4) illustrating a method for bonding the bio-chip 180 shown in FIG. 9;
FIG. 11A is a plan view of a chip 100 according to a fourth embodiment of the present invention;
FIG. 11B is a cross-sectional view along the E-E' line in FIG. 11A;
FIG. 12A is an explanatory diagram (1) of the movement of the chip 100 to which pressure is applied from the outside to the inside of the chip 100;
FIG. 12B is an explanatory diagram (2) of the movement of the chip 100 to which pressure is applied from the outside to the inside of the chip 100;
FIG. 12C is an explanatory diagram of the movement of the chip 100 to which pressure is applied from the inside to the outside of the chip 100;
FIG. 13 is a graph of experiment results, illustrating the optical absorption characteristics of substrates manufactured when the carbon black content and the substrate manufacturing method were varied; and
FIG. 14 is an explanatory diagram of the manufacturing process when a transparent plate having an irregular surface is interposed between the first thermoplastic resin substrate 10 and a piece of quartz glass 40.

### BEST MODE FOR CARRYING OUT THE INVENTION

### Summary of the Invention

In a microfluid chip formed by bonding a first substrate to a second substrate, a main body of at least one of the first substrate and the second substrate is formed from an optically transmissive material that transmits light. Also, at least part of the bonding faces of the first substrate and the second substrate are formed from a thermoplastic resin that contains an optically absorbent substance that absorbs light. Here, when light is directed from above the substrate that transmits light, the light reaches the optically absorbent substance on the bonding faces. When this optically absorbent substance absorbs light, the thermoplastic resin containing the optically absorbent substance is heated and melts. The molten thermoplastic resin is then cooled and cured to bond the first and second substrates together.

Because the above microfluid chip is produced without using an adhesive agent for bonding, damage to the substrates, such as deformation of the pattern in the substrate by outflow of the adhesive agent, can be suppressed. Accordingly, a microfluid chip with good flow control can be produced without impeding the flow of a fluid through the channel. Also, since the bonding faces generate heat locally because of the optically absorbent substance located on the bonding faces, the destruction or deformation of substrates themselves by heat, and the deactivation of the biological substance in the substrates can be prevented.

Also, since there is no need for the substrates to be pressed tightly together at the time of their bonding, damage to the pattern within the substrates or to the substrates themselves can be prevented.

### First Embodiment

### Chip Structure

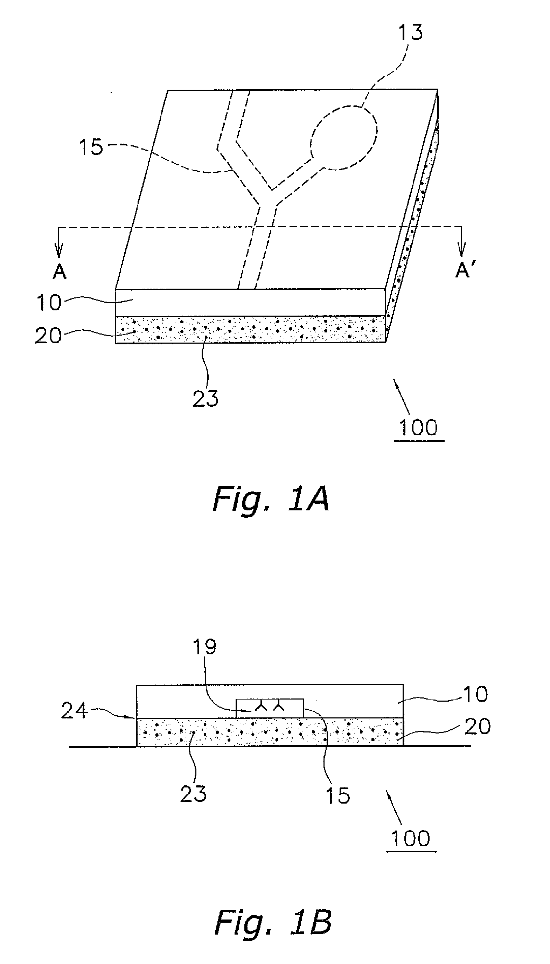

FIG. 1A is a plan view of a chip according to a first embodiment of the present invention, and FIG. 1B is a cross-sectional view along the A-A' line in FIG. 1A. A chip 100 includes a first thermoplastic resin substrate 10 and a second thermoplastic resin substrate 20 that are made of a thermoplastic resin, and these substrates are bonded together at bonding faces 24. A bonding face 24a of the first thermoplastic resin substrate 10 is bonded to a bonding face 24b of the second thermoplastic resin substrate 20. Examples of thermoplastic resins include polyethylene terephthalate (PET), polyethylene, polypropylene, polystyrene, polycarbonate, PMMA (polymethyl methacrylate), ABS (acrylonitrile-butadiene-styrene) resin, polyacetal (polyoxymethylene), and polyamide.

Carbon black is dispersed as an optical absorption agent that absorbs light in the second thermoplastic resin substrate 20. This carbon black is in the form of microparticles of graphite with a particle size of approximately 20 nm, and absorbs laser light. The second thermoplastic resin substrate 20 here is produced by patterning a thermoplastic resin into which carbon black has been kneaded. Meanwhile, the first thermoplastic resin substrate 10 does not contain an optical absorption agent, so that it can transmit light. A reagent reservoir 13 and a channel 15 are formed by removing part of the main face of the first thermoplastic resin substrate 10. The reagent reservoir 13 holds a reagent used to detect a substance to be measured (measurement object) or the like. The channel 15 is formed with its side walls being the main face of the second thermoplastic resin substrate 20 and a groove formed in the first thermoplastic resin substrate 10, and the substance to be measured passes through this channel. As shown in FIG. 1A, a detection substance 19 for detecting the substance to be measured may be fixed to the bottom of the channel 15 at the desired location of the chip 100. The detection substance 19 or the reagent is, for example, peroxidase, cholesterol oxidase, cholesterol esterase, or another such enzyme, or a protein, antigen, antibody, bacteria, yeast, micro-organism, or other such biological substance, a chemical substance, or the like. Examples of the substance to be measured include glucose or cholesterol in blood.

### Substrate Bonding Method

### (1) Bonding by full-surface irradiation

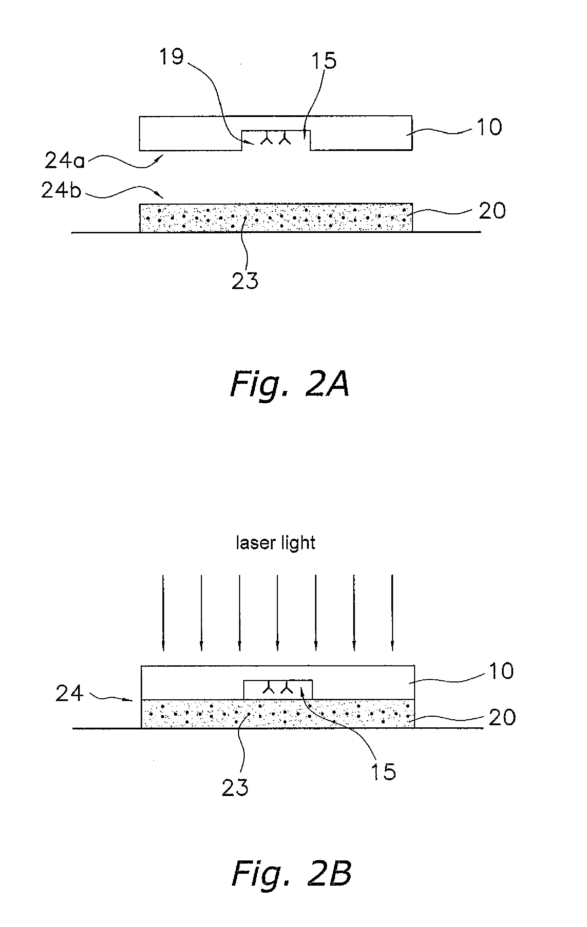

Next, the method for bonding the first thermoplastic resin substrate 10 and the second thermoplastic resin substrate 20 of the chip 100 shown in FIG. 1 will be described through reference to FIGS. 2A and 2b, which are cross-sectional views illustrating the method for bonding the first thermoplastic resin substrate 10 and the second thermoplastic resin substrate 20.

First, the main face of the first thermoplastic resin substrate 10 in which the channel 15 has been formed is positioned across from the second thermoplastic resin substrate 20. In other words, the bonding face 24a of the first thermoplastic resin substrate 10 is positioned across from the bonding face 24b of the second thermoplastic resin substrate 20 (see FIG. 2A). A laser beam is then directed from above the first thermoplastic resin substrate 10 toward the bonding faces 24 (the bonding face 24a and the bonding face 24b) of the first and second thermoplastic resin substrates 10 and 20 (see FIG. 2B).

Here, the first thermoplastic resin substrate 10 contains no carbon black, and the irradiating laser beam passes through the first thermoplastic resin substrate 10. Also, the laser beam transmitted by the first thermoplastic resin substrate 10 reaches the bonding faces 24 of the first thermoplastic resin substrate 10 and the second thermoplastic resin substrate 20, formed by kneading in carbon black. In particular, since the laser beam is coherent light, the area near the bonding faces 24 (the focal point) can be locally irradiated. The laser beam that has reached the bonding faces 24 is absorbed and converted into heat by the carbon black located near the bonding face 24 inside the second thermoplastic resin substrate 20. Once this heat reaches the melting point of the first thermoplastic resin substrate 10 and/or the second thermoplastic resin substrate 20 near the bonding faces 24, the first thermoplastic resin substrate 10 and/or the second thermoplastic resin substrate 20 melts. The molten thermoplastic resin is then cooled and cured, thereby bonding together the first thermoplastic resin substrate 10 and the second thermoplastic resin substrate 20.

### (2) Bonding by partial irradiation

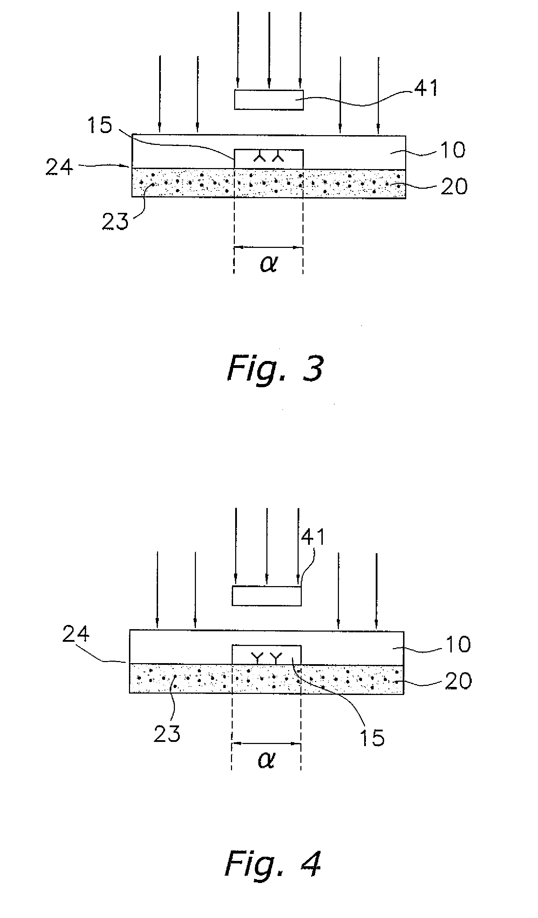

The entire surface of the first thermoplastic resin substrate 10 was irradiated with the laser beam above, but as discussed below, a mask can also be used so that only part of the surface is irradiated with the laser beam. FIG. 3 is a cross-sectional view illustrating a method for bonding substrates by partial irradiation using a mask. As shown in FIG. 3, a mask 41 that blocks laser beams is disposed over the portion corresponding to the channel 15 in which the detection substance 19 is fixed. When the first thermoplastic resin substrate 10 is irradiated with a laser beam from above the mask 41, the portion indicated by α in FIG. 3 and corresponding to the mask 41 is not irradiated by the laser beam. Thus, since the detection substance 19 fixed in the channel 15 is not irradiated by the laser beam, deactivation of the detection substance 19 can be prevented. Also, since the α portion is not irradiated by the laser beam, heat is not generated at the surface of the second thermoplastic resin substrate 20 in the α portion, and the substrate does not melt there. This prevents the channel 15 from being deformed by the melting of the substrate, and the flow of fluid through the channel 15 is not impeded.

Also, when the mask 41 is used, the detection substance 19 can be fixed to the surface of the second thermoplastic resin substrate 20 as shown in FIG. 4. FIG. 4 is an explanatory diagram illustrating a case in which the detection substance 19 is fixed to the surface of the second thermoplastic resin substrate 20, and the location where the detection substance 19 is fixed is different from that shown in FIG. 3. When bonding is performed by the full-surface irradiation shown in FIG. 2, the detection substance 19 is preferably fixed to the first thermoplastic resin substrate 10, rather than the surface of the second thermoplastic resin substrate 20. This is because the surface of the second thermoplastic resin substrate 20 in which the channel 15 is formed, that is, the bonding face 24, may generate heat when irradiated with the laser beam, causing the detection substance 19 to be deactivated. Thus, in FIG. 1 or FIG. 2, the detection substance 19 is fixed to the channel 15 within the first thermoplastic resin substrate 10. However, if the irradiation with the laser beam is performed while using the mask 41 as shown in FIGS. 3 and 4, heat will be prevented from being generated at the surface of the second thermoplastic resin substrate 20, and therefore the detection substance 19 can be fixed to the surface of the second thermoplastic resin substrate 20 while the deactivation of the detection substance 19 is prevented. This affords latitude in choosing the location where the detection substance 19 is to be fixed.

### (3) Laser beam

The laser beam that irradiates the substrates is produced by a laser oscillator featuring a semiconductor laser, for example. However, the type of oscillator is not limited so long as wavelength and power of the laser beam can be suitably set.

The wavelength of the irradiating laser beam is selected according to the optical transmissivity of the first thermoplastic resin substrate 10, the properties of the optical absorption agent in the second thermoplastic resin substrate 20, the properties of the reagent in the reagent reservoir 13, the properties of the detection substance 19 in the channel 15, and so forth.

For example, carbon black absorbs light in inverse proportion to the wavelength of the light, so the shorter is the wavelength, the more efficiently light will be absorbed and heat generated. The first thermoplastic resin substrate 10 transmits a laser beam having a wavelength between approximately 300 nm and 2.5 µm. If the detection substance 19 is a biological substance made up of macromolecules, it must be protected from being decomposed and deactivated by a photochemical reaction brought about by the laser beam. For instance, UV light and other such short-wavelength light have high energy, so there is the danger that it will break the covalent bonds of the detection substance and deactivate it. The bond dissociation energy of the C-C bonds, C-N bonds, C-O bonds, and so forth constituting the macromolecules is approximately 300 kJ/mol or higher. Thus, a laser beam with a wavelength of approximately 400 nm or greater is required to be selected so as not to deactivate the detection substance 19. When the above is taken into account, a wavelength suited to a variety of resin materials is selected from within a range of approximately 400 nm or greater to 2.5 µm or less, for example, as the wavelength of the laser beam used for irradiation.

Furthermore, the heat that is generated can be restricted to just the bonding faces by keeping the laser beam irradiation time short.

### Effects

With this bonding method, there is no need to use an adhesive agent to bond the substrates together. Thus, damage to the substrates, such as deformation of the pattern in the substrate by outflow of the adhesive agent, can be prevented, and the flow of a fluid through the channel 15 will not be impeded.

Also, because the light that has passed through the first thermoplastic resin substrate 10 is absorbed by the carbon black located near the bonding faces 24, heat generation is restricted to just the bonding faces 24. That is, the first and second thermoplastic resin substrates 10 and 20 are not subjected to heat in their entirety, and instead the thermoplastic resin of the bonding faces 24 is melted by localized heat generation, thereby bonding the substrates together. Thus, the destruction or deformation of the entire substrates by heat generation in their entirety, along with the deactivation of the detection substance 19 disposed in the channel 15 of the first thermoplastic resin substrate 10, can be prevented. Also, the side walls of the reagent reservoir 13 or the channel 15 can be prevented from melting and impeding the reaction of the detection substance 19.

Also, since there is no need to press the substrates together at the time of their bonding, the destruction or deformation of the patterns of the reagent reservoir 13, the channel 15, etc., formed in the first thermoplastic resin substrate 10 by pressing force can be prevented. The destruction or deformation of the substrates themselves by pressing force can also be prevented.

### First Embodiment

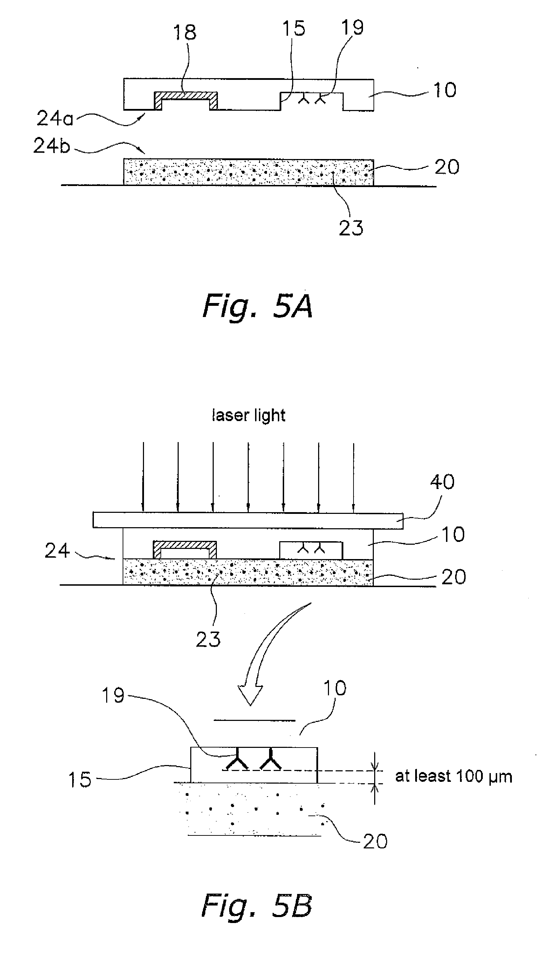

FIGS. 5A and 5B will be used to describe the method for bonding the chip 100 according to the first embodiment given above. FIGS. 5A and 5B are cross-sectional views illustrating a method for bonding the first thermoplastic resin substrate 10 and the second thermoplastic resin substrate 20. Polyethylene terephthalate (PET) with a thickness of 1 mm, a length of 25 mm, and a width of 25 mm was used for the first thermoplastic resin substrate 10 and the second thermoplastic resin substrate 20. PET in which carbon black had been dispersed was used for the second thermoplastic resin substrate 20. PET has a melting point of 245°C and a tensile elastic modulus of 421 Kgf/mm². A channel 15 with a width of 100 µm and a depth of 200 µm was formed in a main face of the first thermoplastic resin substrate 10. Also, to control the flow of fluid, part of the channel 15 was coated with cellulose acetate by casting, the other portion was coated with polystyrene, and the coatings were dried. As shown in FIGS. 5A and 5B, an antibody that reacted with protein was fixed as the detection substance 19 to part of the channel 15 in the first thermoplastic resin substrate 10. The detection substance 19 was fixed in the first thermoplastic resin substrate 10 so as to be at least 100 µm away from the location where the carbon black was introduced. That is, the detection substance 19 was kept apart from the bonding faces 24 of the first and second thermoplastic resin substrates 10 and 20 to protect it from the effect of the heat generated in the bonding of the substrates.

The bonding method will now be described in specific terms. First, as shown in FIG. 5A, the main face of the first thermoplastic resin substrate 10 on which the channel 15 was formed was disposed across from the second thermoplastic resin substrate 20. Here, the bonding face 24a of the first thermoplastic resin substrate 10 was disposed across from the bonding face 24b of the second thermoplastic resin substrate 20. Then, as shown in FIG. 5B, the first and second thermoplastic resin substrates 10 and 20 were fastened together by pressing at 0.3 MPa over the entire surface of the first thermoplastic resin substrate 10 via the quartz glass 40. The pressure was adjusted according to the strength of the substrates, since excessive pressure would destroy the patterns of the channel 15 and so on.

Next, as shown in FIG. 5B, the first thermoplastic resin substrate 10 was irradiated through the quartz glass 40 with a laser beam having a wavelength of 940 µm and a power of 30 W. The spot diameter of this laser beam was 5 mm, and irradiation was performed at a scanning speed of 20 mm/s. The irradiation time at a given point here was 0.25 second.

When the irradiating laser beam raises the temperature of the bonding faces 24 of the first and second thermoplastic resin substrates 10 and 20 to the melting point of PET (245°C), the bonding faces 24 melt and the substrates are bonded together. It was discovered that heat distribution here is limited to a local range of not more than 100 µm from the bonding faces. Also, since the irradiation time is only 0.25 second, heat generated at the bonding faces could be prevented from diffusing. And because the detection substance 19 was fixed at a location at least 100 µm away from the bonding faces, deactivation of the detection substance 19 by heat generated at the bonding faces could also be prevented. Furthermore, good flow control could be achieved within the channel 15 by coating the channel 15 with cellulose acetate and polystyrene. This is because the flow within the channel 15 can be controlled by coating a portion of the channel 15 with cellulose acetate, which is a hydrophilic macromolecular film, and coating the other portion with polystyrene, which is a hydrophobic macromolecular film.

### Second Embodiment

### Chip Structure

### (1) Full-surface optical absorption layer

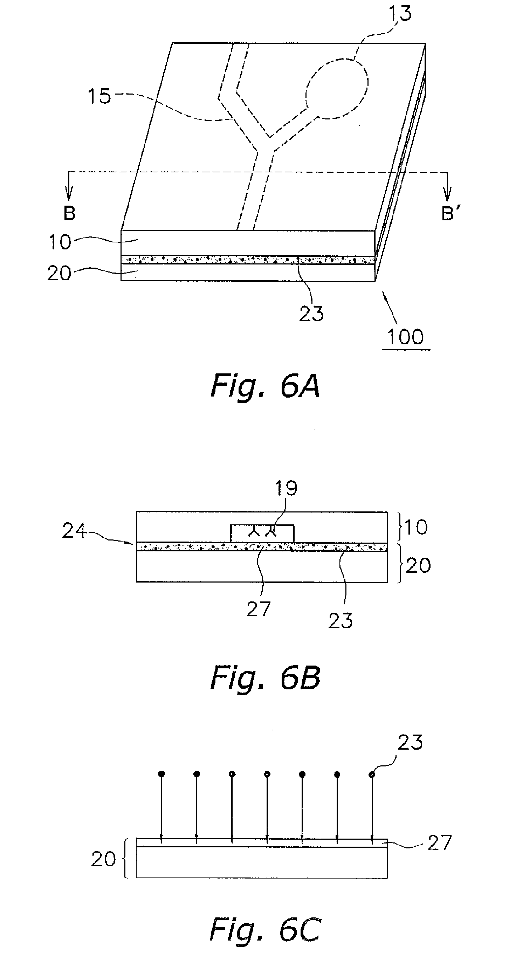

FIG. 6A is a plan view of a chip according to a second embodiment of the present invention, FIG. 6B is a cross-sectional view along the B-B' line in FIG. 6A, and FIG. 6C is a cross-sectional view illustrating a method for forming an optical absorption layer. A chip 100 includes a first thermoplastic resin substrate 10 and a second thermoplastic resin substrate 20 that are made from thermoplastic resin, and the substrates are bonded together at bonding faces 24.

The second thermoplastic resin substrate 20 has an optical absorption layer 27 that contains carbon black as an optical absorption agent 23 that absorbs light. As shown in FIG. 6C, the optical absorption layer 27 here is formed by spin coating the entire surface of the second thermoplastic resin substrate 20 with a solution containing carbon black, for example. The first and second thermoplastic resin substrates 10 and 20 are bonded together via the bonding faces 24 of the optical absorption layer 27 of the second thermoplastic resin substrate 20 and the first thermoplastic resin substrate 10. Meanwhile, the first thermoplastic resin substrate 10 does not contain an optical absorption agent, so that it will be able to transmit light, and has a reagent reservoir 13 and a channel 15 formed by removing part of a main face. The channel 15 is formed with its side walls being the main face of the second thermoplastic resin substrate 20 and a groove formed in the first thermoplastic resin substrate 10, and the substance to be measured passes through this channel. As shown in FIG. 6A, a detection substance 19 for detecting the substance to be measured may be fixed to the bottom of the channel 15 at the desired location of the chip 100.

### (2) Partial optical absorption layer

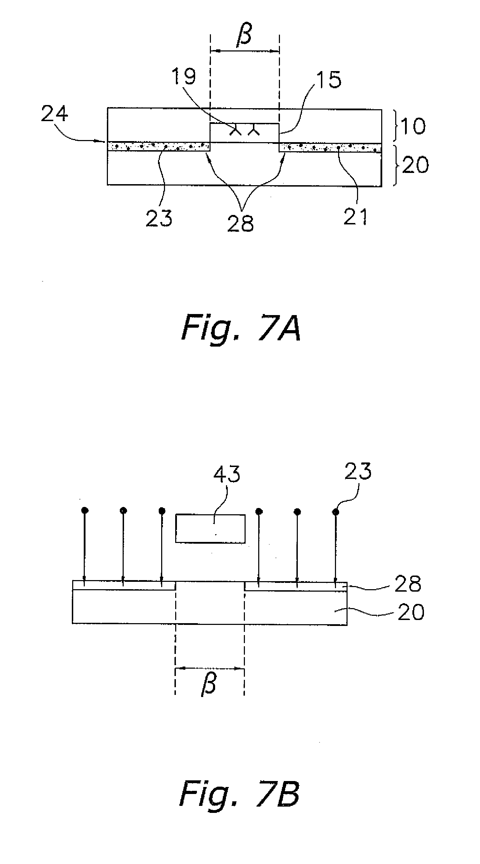

In the above-mentioned FIGS. 6A to 6C, the optical absorption layer 27 was provided over the entire surface of the second thermoplastic resin substrate 20, but a partial optical absorption layer 28 can be also provided as follows. FIG. 7A is a cross-sectional view of a substrate having a partial optical absorption layer 28, and FIG. 7B is a cross-sectional view illustrating a method for forming a partial optical absorption layer 28.

As shown in FIG. 7B, the partial optical absorption layer 28 is formed by disposing a mask 43 in the portion indicated by β in FIG. 7 and corresponding to the channel 15, and injecting the optical absorption agent 23 onto the surface of the second thermoplastic resin substrate 20 via this mask 43. The first and second thermoplastic resin substrates 10 and 20 are bonded together at the bonding faces 24 of the partial optical absorption layer 28 of the second thermoplastic resin substrate 20 and the first thermoplastic resin substrate 10. Here, as shown in FIG. 7A, the optical absorption layer containing the optical absorption agent 23 is not in contact with the walls of the channel 15. Thus, when the laser beam is directed from above the first thermoplastic resin substrate 10, it passes through the β portion of the second thermoplastic resin substrate 20. Therefore, the walls of the channel 15 located in the β portion do not generate heat and melt. This affords latitude in choosing the location where the detection substance 19 is to be fixed, such as allowing the detection substance 19 to be fixed on the surface of the second thermoplastic resin substrate 20 constituting part of the walls of the channel 15.

### Substrate Bonding Method

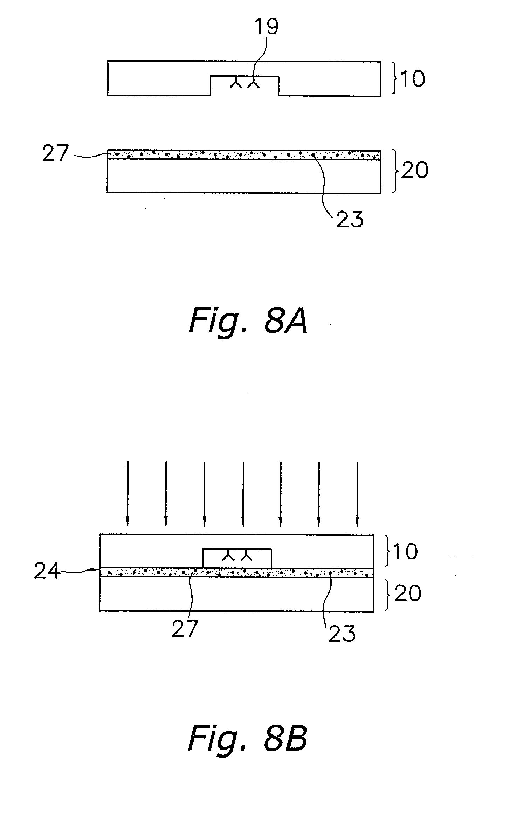

Next, the method for bonding the first thermoplastic resin substrate 10 and the second thermoplastic resin substrate 20 of the chip 100 shown in FIGS. 6A and 6B will be described through reference to FIGS. 8A and 8B, which are cross-sectional views illustrating the method for bonding the first thermoplastic resin substrate 10 and the second thermoplastic resin substrate 20.

First, the main face of the first thermoplastic resin substrate 10 in which the channel 15 has been formed is positioned across from the optical absorption layer 27 of the second thermoplastic resin substrate 20. Here, the β portion where the optical absorption layer 27 is not formed is located across from the portion corresponding to the channel 15 of the first thermoplastic resin substrate 10 (see FIG. 8A). The laser beam is directed from above the first thermoplastic resin substrate 10 toward the bonding faces 24 of the first and second thermoplastic resin substrates 10 and 20 (see FIG. 8B).

The laser beam that has passed through the first thermoplastic resin substrate 10 here reaches the bonding faces 24 of the optical absorption layer 27 of the second thermoplastic resin substrate 20 and the first thermoplastic resin substrate 10. As a result, the carbon black in the optical absorption layer 27 generates heat, and the first thermoplastic resin substrate 10 and/or the second thermoplastic resin substrate 20 at the bonding faces 24 melts and the substrates are bonded together.

As shown in FIG. 3 of the first embodiment, the substrates may be bonded by partial irradiation. That is, when the substrates are irradiated with the laser beam and bonded, a mask 41 that blocks laser beams is disposed over the portion corresponding to the channel 15 in which the detection substance 19 is fixed. As a result, the optical absorption layer 27 corresponding to the channel 15 is not irradiated with the laser beam, so deformation of the channel 15 by melting can be prevented, and the flow of fluid through the channel 15 is not impeded. Furthermore, since the optical absorption layer 27 that forms the channel 15 does not generate any heat, the detection substance 19 will not be deactivated even if fixed on the optical absorption layer 27. This affords latitude in choosing the location where the detection substance 19 is to be fixed.

### Effects

Providing the optical absorption layer 27 to the surface of the second thermoplastic resin substrate 20 allows the heat generation portion to be limited to the substrate surface, and be more localized. Thus, deformation of the substrates, and deformation of the patterns of the channel and so forth formed in the substrates by heat generation in their entirety can be prevented. Also, deactivation of the detection substance 19 disposed in the channel 15 of the first thermoplastic resin substrate 10 by heat can be prevented. Furthermore, the side walls of the reagent reservoir 13 or the channel 15 can be prevented from being melted by generated heat and impeding the reaction of the detection substance 19.

Also, if the entire second thermoplastic resin substrate 20 contains an optical absorption agent, the laser beam irradiation time has to be set short enough to suppress the spread of heat generation. However, by providing the optical absorption layer 27 to just the surface of the second thermoplastic resin substrate 20, the spread of heat generation can be suppressed without controlling the laser beam irradiation time.

Furthermore, since the optical absorption layer 27 is provided to the substrate surface, the amount of carbon black or other optical absorption agent can be kept small.

Also, the following effects can be obtained just as in the first embodiment. With the bonding method of the second embodiment, there is no deformation of the pattern within the substrates due to the outflow of adhesive agent, and the flow of fluid through the channel 15 is not impeded. Furthermore, since there is no need for the substrates to be pressed tightly together at the time of their bonding, the destruction or deformation, etc. of the pattern within the substrates or of the substrates themselves due to pressing can be prevented.

### Third Embodiment

### Chip Structure

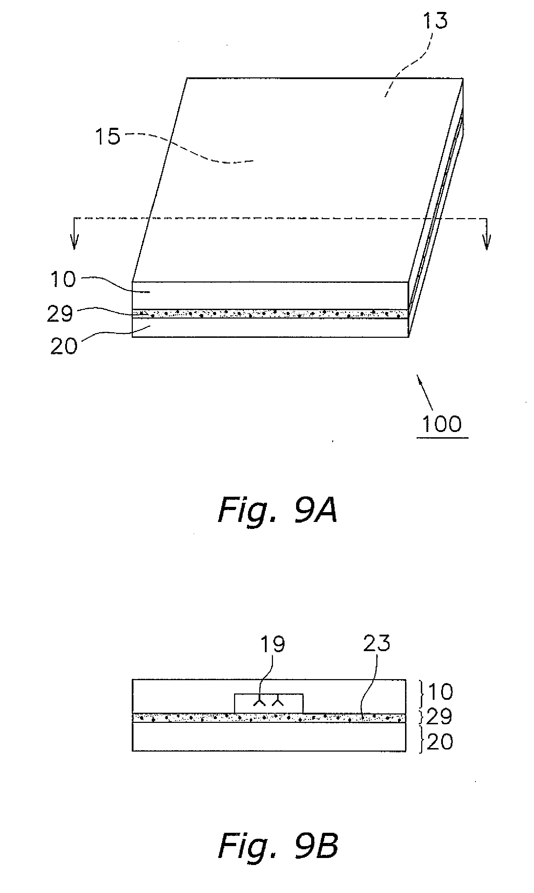

FIG. 9A is a plan view of a chip according to a third embodiment of the present invention, and FIG. 9B is a cross-sectional view along the C-C' line in FIG. 9A. An optically absorbent substrate 29 is sandwiched between a first thermoplastic resin substrate 10 and a second thermoplastic resin substrate 20 that are made of a thermoplastic resin in a chip 100. A thermoplastic elastomer containing carbon black (as an optical absorption agent 23) is used as the optically absorbent substrate 29 here. This thermoplastic elastomer is a polymer material based on styrene, olefin, vinyl chloride, urethane, ester, amide, or the like.

The first and second thermoplastic resin substrates 10 and 20 do not contain an optical absorption agent, so that they can transmit light. A reagent reservoir 13 and a channel 15 are formed by removing part of the main face of the first thermoplastic resin substrate 10. The channel 15 is formed with its side walls being the main face of the optically absorbent substrate 29 and a groove formed in the first thermoplastic resin substrate 10, and the substance to be measured passes through this channel. As shown in FIG. 9A, a detection substance 19 for detecting the substance to be measured may be fixed to the bottom of the channel 15 at the desired location of the chip 100. The detection substance 19 or the reagent is, for example, peroxidase, cholesterol oxidase, cholesterol esterase, or another such enzyme, or a protein, antigen, antibody, bacteria, yeast, micro-organism, or other such biological substance, a chemical substance, or the like.

### Substrate Bonding Method

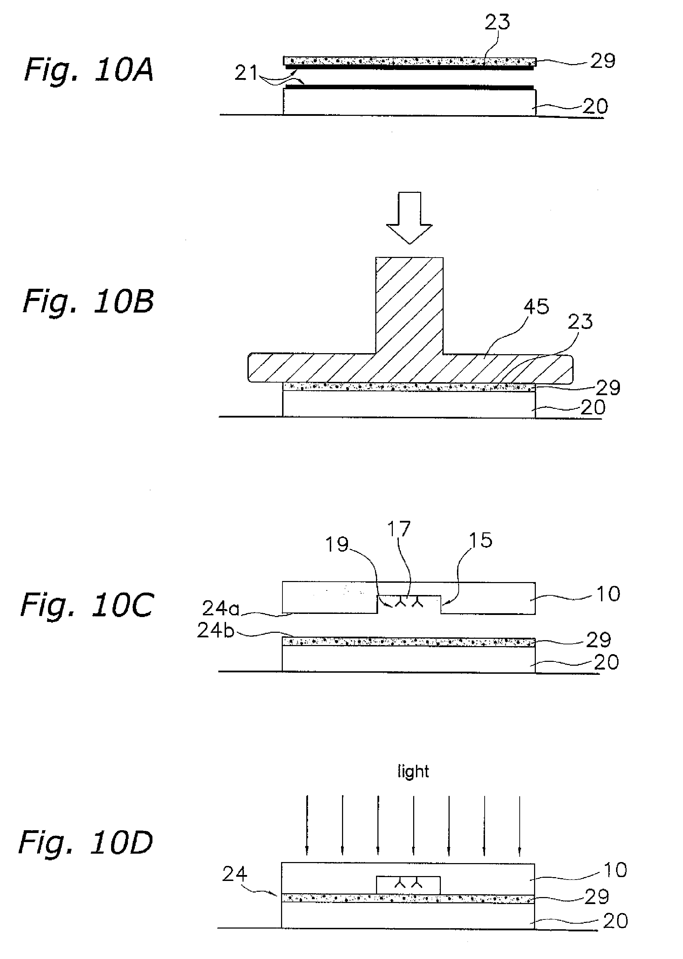

Next, the method for bonding the first thermoplastic resin substrate 10 and the second thermoplastic resin substrate 20 via the optically absorbent substrate 29 of the chip 100 shown in FIGS. 9A and 9b will be described through reference to FIGS. 10A to 10D, which are cross-sectional views illustrating the method for bonding the first thermoplastic resin substrate 10 and the second thermoplastic resin substrate 20 via the optically absorbent substrate 29.

First, the second thermoplastic resin substrate 20 is disposed across from the optically absorbent substrate 29. The facing surfaces here are coated with an adhesive agent 21 (see FIG. 10A). Pressure is applied with a horn 45 from above the optically absorbent substrate 29, and the second thermoplastic resin substrate 20 and optically absorbent substrate 29 are bonded together (see FIG. 10B). Then, the main face of the first thermoplastic resin substrate 10 in which the channel 15 has been formed is disposed across from the optically absorbent substrate 29. Here, a bonding face 24a of the first thermoplastic resin substrate 10 is disposed across from a bonding face 24b of the optically absorbent substrate 29 (see FIG. 10C). The laser beam is then directed from above the first and second thermoplastic resin substrate 10 toward the bonding faces 24 (the bonding face 24a and the bonding face 24b) of the first thermoplastic resin substrates 10 and the optically absorbent substrate 29 (see FIG. 10D).

The first thermoplastic resin substrate 10 here does not contain carbon black, so the irradiating laser beam passes through the first thermoplastic resin substrate 10. Also, the laser beam transmitted by the first thermoplastic resin substrate 10 reaches the bonding faces 24 of the first thermoplastic resin substrate 10 and the optically absorbent substrate 29, which contains carbon black. The carbon black in the optically absorbent substrate 29 generates heat as a result, and the first thermoplastic resin substrate 10 and/or the optically absorbent substrate 29 at the bonding faces 24 melt and the substrates are bonded together.

### Effects

The above-mentioned optically absorbent substrate 29 is not limited to being a thermoplastic elastomer, and may instead be made of the same thermoplastic resin as the substrate, for example. However, water-tightness and air-tightness can be improved by forming the optically absorbent substrate 29 from a thermoplastic elastomer. This is because a thermoplastic elastomer is thermoplastic and has rubber elasticity, so it can improve adhesion strength between the first and the second thermoplastic resin substrates 10 and 20. In particular, water-tightness and air-tightness can be maintained even with a large chip surface area.

Further, the same effects as in the first embodiment can be obtained with this third embodiment. There is no deformation of the pattern within the substrate due to the outflow of an adhesive agent, and the flow of fluid through the channel 15 is not impeded. Also, since there is no need for the substrates to be pressed tightly together at the time of their bonding, the destruction or deformation, etc., of the pattern within the substrates or of the substrates themselves due to pressing can be prevented.

### Fourth Embodiment

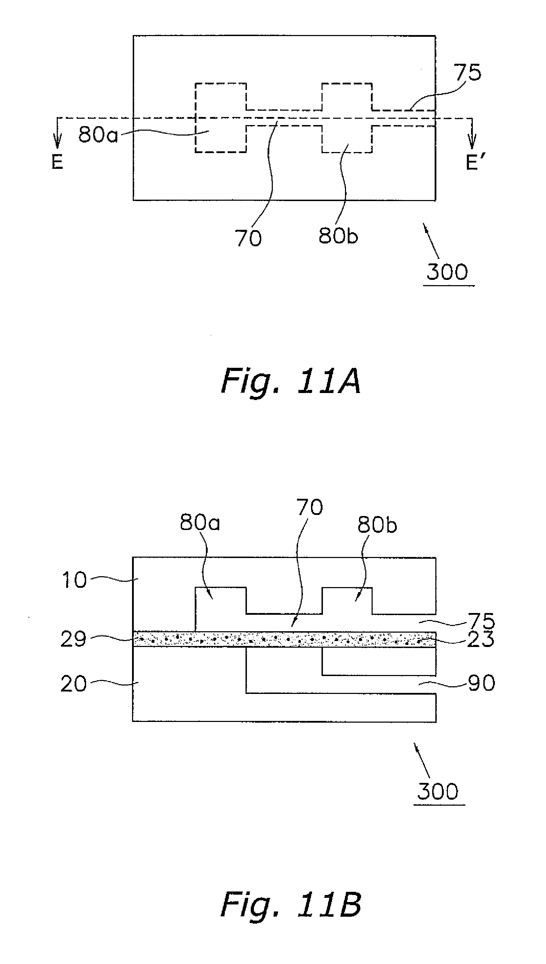

FIG. 11A is a plan view of a chip 100 according to a fourth embodiment of the present invention, and FIG. 11B is a cross-sectional view along the E-E' line in FIG. 11A.

An optically absorbent substrate 29 is sandwiched between a first thermoplastic resin substrate 10 and a second thermoplastic resin substrate 20 in the chip 100. The first and second thermoplastic resin substrates 10 and 20 here are made of a thermoplastic resin. The optically absorbent substrate 29 is a thermoplastic elastomer containing carbon black as an optical absorption agent 23.

A main face of the first thermoplastic resin substrate 10 is provided with a first opening 80a, a second opening 80b, a first channel 70 that connects the first opening 80a and second opening 80b, and a second channel 75 that connects the second opening 80b to outside the chip 100. The second thermoplastic resin substrate 20 is provided with a third channel 90 with which pressure is applied to the interior or exterior of the chip 100. As shown in FIG. 11B, the portion of the main face of the second thermoplastic resin substrate 20 where the third channel 90 opens corresponds to the first channel 70 of the first thermoplastic resin substrate 10.

The chip 100 is formed as follows by irradiation with a laser beam. The first thermoplastic resin substrate 10 contains no carbon black, so the irradiating laser beam passes through the first thermoplastic resin substrate 10. Also, the laser beam transmitted by the first thermoplastic resin substrate 10 reaches the bonding faces 24 of the first thermoplastic resin substrate 10 and the optically absorbent substrate 29, which contains carbon black. The result is that the carbon black in the optically absorbent substrate 29 generates heat and melts the first thermoplastic resin substrate 10 and/or the optically absorbent substrate 29 at the bonding faces 24, bonding the substrates together. Thus, pattern destruction and so forth can be prevented in the first, second, and third channels 70, 75, and 90, the first and second openings 80a and 80b, and so on. Also, since the optically absorbent substrate 29 is thermoplastic and has rubber elasticity, it can improve adhesion strength between the first and the second thermoplastic resin substrates 10 and 20, which improves water-tightness and air-tightness.

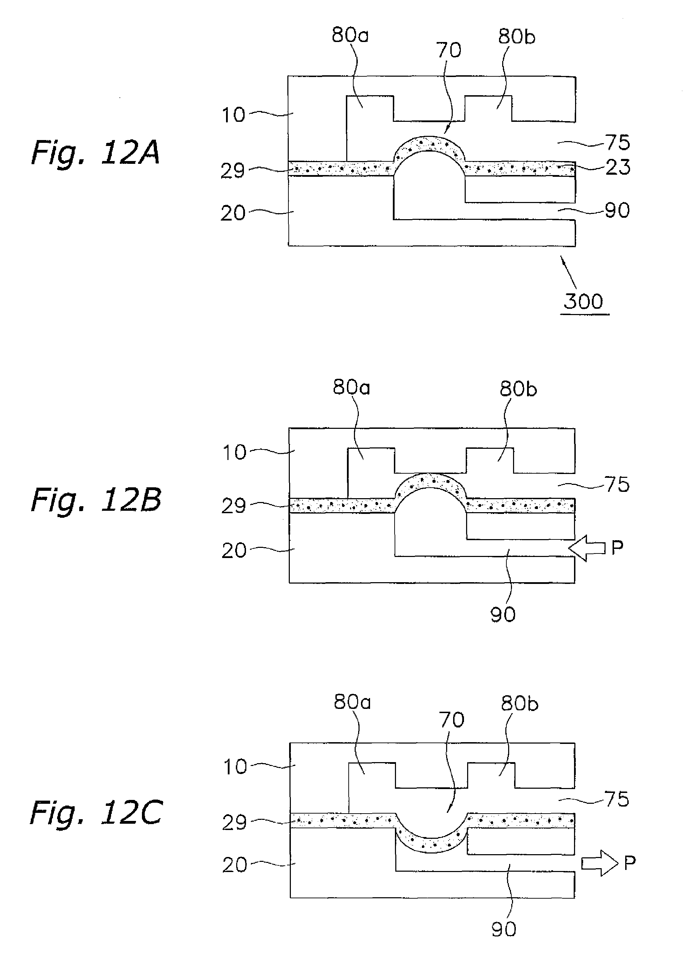

FIGS. 12A and 12B are explanatory diagrams of the movement of the chip 100 to which pressure is applied from the outside to the inside of the chip 100, and FIG. 12C is an explanatory diagram of the movement of the chip 100 to which pressure is applied from the inside to the outside of the chip 100. As shown in FIG. 12A, if pressure is applied to the third channel 90 from the outside to the inside of the chip 100, the optically absorbent substrate 29 is subjected to this pressure at the portion where the third channel 90 opens in the main face of the second thermoplastic resin substrate 20. At this point the optically absorbent substrate 29 stretches so as to narrow the passage through the first channel 70 connecting the first opening 80a and the second opening 80b. Thus, fluid in the first and second openings 80a and 80b is guided out through the second channel 75 to outside the chip 100 (see, FIG. 12A). Then, when pressure is applied to the third channel 90 from the outside to the inside of the chip 100, the optically absorbent substrate 29 stretches so as to block off the first channel 70. Thus, the flow of fluid is halted between the first opening 80a and the second opening 80b (see FIG. 12B).

Then, as shown in FIG. 12C, if pressure is applied to the third channel 90 from the inside to the outside of the chip 100, the optically absorbent substrate 29 stretches so that it is pulled toward the second thermoplastic resin substrate 20. Thus, fluid is taken into the chip 100 through the second channel 75, for example. In this way, the optically absorbent substrate 29 with rubber elasticity can be used as a valve or pump for opening and closing the first opening 80a and second opening 80b.

### Other Embodiments

### (1)

In the above, if the melting points of the substrates to be bonded are about the same, then when the optical absorption agent near the bonding faces of the substrates is irradiated with light, the bonding faces of the substrates will melt at substantially the same time, making it easier to bond the substrates together.

### (2)

Carbon black was used as the optical absorption agent above, but a colorant of a different color may be used instead. It is preferable for a colorant with a different color to be used for every substance to be measured because the user will be able to easily confirm the chip to be used in measurement. This prevents the user from picking up the wrong chip when measuring a variety of substances such as glucose and cholesterol, for instance.

### (3)

In the above, a macromolecular film may be disposed on the surface of the channel 15 or the reagent reservoir 13 formed in the substrate, according to the properties of the fluid passing through the interior thereof, the properties of the reagent being held, the properties of the detection substance 19 being fixed, and so forth. For example, let us assume that the substance to be measured is blood with a viscosity of approximately 4 to 15, and that the viscosity of the reagent, etc., in the chip is 1. When solutions whose viscosities are thus markedly different are to be mixed, reacted, or detected within a single chip, it can be difficult to control the fluid. For instance, with a solution with high viscosity or a solution with high surface tension, its viscosity may cause the solution to stop flowing, or its surface tension may cause the solution to be repelled, which slows down the flow. On the other hand, a solution that has low viscosity will flow through the channel 15 without resistance. Thus, different viscosities can result in incomplete mixing or reaction, and make it difficult to accurately detect the substance to be tested. In view of this, the surface of the portion with a channel, etc., is subjected to a hydrophilic treatment, and the surface of the other portion is subjected to a hydrophobic treatment to control the fluid in the channel. Examples of hydrophilic macromolecular films include cellulose acetate, polyvinyl alcohol (PVA), and polyvinylpyrrolidone (PVP). Examples of hydrophobic macromolecule include polystyrene (PS), polyethylene (PE), Teflon^{®}, and silicon like that.

### (4)

In the above, the detection substance is preferably fixed at least 100 µm away form the location where the optically absorbent substance is introduced. The optically absorbent substance absorbs the irradiating light and generates heat. Disposing the detection substance a predetermined distance away from this optically absorbent substance prevents the detection substance from being deactivated by heat generated during substrate bonding.

### (5)

In the above, a laser beam, which is coherent light, is used to irradiate the bonding faces of the first and second thermoplastic resin substrates 10 and 20, but the light is not limited to being a laser beam, as long as the bonding faces can be irradiated with light.

### (6)

In the above, both of the substrates to be bonded were formed from a thermoplastic resin, but only one of them needs to be a thermoplastic resin. For instance, one may be a thermoplastic resin substrate and the other made from metal, glass, or the like. It is preferable here to form the pattern of the channel, the reagent reservoir, or the like in a thermoplastic resin substrate that is easier to work than metal, glass, and the like.

### (7)

In the above, the channel 15 is formed in the first thermoplastic resin substrate 10, but may instead be formed in the second thermoplastic resin substrate 20. Also, the channel 15 may be formed by combining a groove formed in the first thermoplastic resin substrate 10 with a groove formed in the second thermoplastic resin substrate 20.

### (8)

The second thermoplastic resin substrate 20 in the first embodiment above was formed by kneading carbon black into the material, and the carbon black content in the second thermoplastic resin substrate 20 is preferably at least 0.01 vol% and not more than 0.025 vol%.

As discussed above, a solution of blood, a reagent, or another such sample is introduced into the channel 15, etc., in FIG. 2 and a biochemical reaction is conducted. Part of the channel 15 is formed form the second thermoplastic resin substrate 20, and the solution introduced into the channel 15 contacts with the second thermoplastic resin substrate 20. If the second thermoplastic resin substrate 20 here contains an excessive amount of carbon black as an optically absorbent substance, the carbon black will be eluted from the second thermoplastic resin substrate 20 into the solution in the channel 15. For instance, the carbon black content is generally at least 0.05 vol% and not more than 0.1 vol%, but a content within this range is too large and the carbon black is eluted from the second thermoplastic resin substrate 20 into the solution in the channel 15. Accordingly, there is the risk that the eluted carbon black would hamper the biochemical reaction or the like in the channel 15. Also, when the channel 15 into which the solution has been introduced is irradiated with light, and a spectroscopic method is used such as measuring the intensity of the transmitted light, the spectrum of the transmitted light, or the intensity of scattered light, any carbon black that has been eluted into the channel 15 acts as an inhibitor that absorbs transmitted light and so forth. Thus, quantification of the sample, such as quantification of the product of a biochemical reaction, cannot be performed accurately. On the other hand, if the carbon black content in the second thermoplastic resin substrate 20 is small, not enough light will be absorbed and bonding will be insufficient. Also, an insufficient amount of the carbon black used as colorant causes color unevenness in the substrate, and this can also result in insufficient substrate bonding.

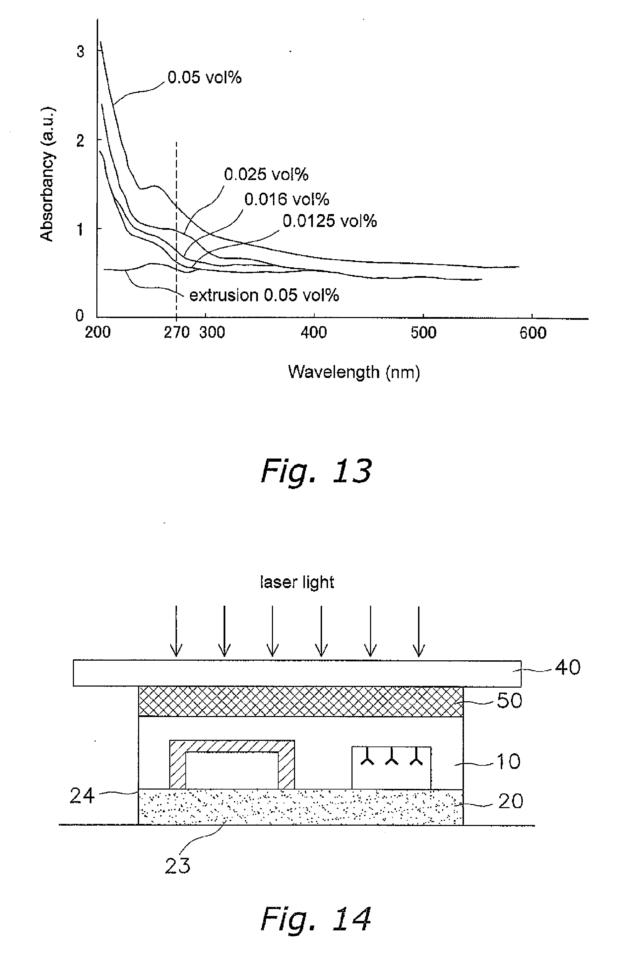

FIG. 13 is a graph of experiment results, illustrating the optical absorption characteristics of substrates manufactured when the carbon black content and the substrate manufacturing method were varied. Substrates were prepared by injection molding and with carbon black contents of 0.0125 vol%, 0.016 vol%, 0.025 vol%, and 0.05 vol%, and a substrate was prepared by extrusion molding and with a carbon black content of 0.05 vol%. These substrates were immersed in pure water, after which the degree of elution of carbon black was measured with an ultraviolet spectrometer. The presence of eluted carbon black can be confirmed because carbon black distinctively absorbs light with a wavelength near 270 nm. As shown in FIG. 13, it can be seen that the absorbancy is highest and the elution of carbon black is most pronounced at a conventional carbon black content of 0.05 vol%. However, it can be seen that the elution of carbon black is suppressed by keeping the content to 0.025 vol% or less as in the present invention.

If, as in the present invention, the carbon black content in the second thermoplastic resin substrate 20 is kept to 0.025 vol% or less, elution of the carbon black into the solution can be suppressed. Thus, biochemical reactions can be conducted properly in the solution in the channel 15, and samples and so forth can be accurately quantified. Also, if the carbon black content is kept to at least 0.01 vol%, there will be no color unevenness in the substrate, and sufficient bonding strength can be ensured between the substrates. Furthermore, injection molding is a simple manufacturing method that is routinely used to form substrates, so being able to use injection molding at the above content affords better productivity and production cost for substrates containing carbon black. Thus keeping the carbon black content within the above range allows efficient use of the carbon black while fully exploiting the characteristics of the carbon black.

The carbon black content discussed above can also be applied to the optical absorption layer 27 and partial optical absorption layer 28, which contain carbon black, in the second embodiment, or to the optically absorbent substrate 29 in the third and fourth embodiments, etc.

### (9)

In the first embodiment, the top of the first thermoplastic resin substrate 10 is uniformly pressed via the quartz glass 40, which has excellent flatness and rigidity, as shown in FIG. 5B and elsewhere, to prevent lift between the first thermoplastic resin substrate 10 and the second thermoplastic resin substrate 20. It is preferable here if a transparent plate having an irregular surface is interposed between the first thermoplastic resin substrate 10 and the quartz glass 40.

Here, since the first thermoplastic resin substrate 10 is made of resin, it is coarsely molded so that its surface will have a more irregular surface than the quartz glass 40. On the other hand, as discussed above, the quartz glass 40 is molded so that its surface will be smooth and flat. Therefore, when the first thermoplastic resin substrate 10 comes into contact with the quartz glass 40, the irregularities in the first thermoplastic resin substrate 10 act as suction cups and the quartz glass 40 ends up sticking to the first thermoplastic resin substrate 10. Once a vacuum state is created and the two stick together, the quartz glass 40 cannot be removed from the first thermoplastic resin substrate, which prevents the chip from being taken out of the pressing apparatus to the outside. If the quartz glass 40 is pulled more forcefully and peeled away from the first thermoplastic resin substrate 10, the adhesive bonding between the first thermoplastic resin substrate 10 and the second thermoplastic resin substrate 20 may be stripped away. In particular, when the first thermoplastic resin substrate 10 has undergone surface modification, surface coating, or other such surface treatment, or has been solvent treated to clean or sterilize it, the surface of the first thermoplastic resin substrate 10 is formed so that it has elasticity, in which case the above problems are even more pronounced.

FIG. 14 is an explanatory diagram illustrating the manufacturing process when a transparent plate having an irregular surface is interposed between the first thermoplastic resin substrate 10 and the quartz glass 40. As shown in FIG. 14, when a transparent plate 50 having an irregular surface is interposed between the first thermoplastic resin substrate 10 and the quartz glass 40, the first thermoplastic resin substrate 10 is prevented from sticking by suction to the transparent plate 50 having an irregular surface. The reason is as follows. The surface of the transparent plate 50 is coarsely molded so as to have irregularities, and the surface of the first thermoplastic resin substrate 10 in contact with the transparent plate 50 is also coarsely molded. This prevents the first thermoplastic resin substrate 10 and the quartz glass 40 from sticking together by suction.

The transparent plate 50 having an irregular surface can be made, for example, from PPMA, APO (amorphous polyolefin), polycarbonate, poly-4-methylpentene-1, or the like. Also, rather than using a thick transparent plate 50, these materials may be worked into a sheet of thin film such as a transparent polyamide (nylon).

Also, to apply the pressure uniformly to the bonding faces of the substrates during pressing, it is ideal to combine a quartz glass 40 having high rigidity with a transparent plate 50 having microscopic irregularities. The phrase "microscopic irregularities" means that the size of the irregularities is approximately 0.1 to approximately 1.0 µm or larger, for example. Furthermore, a transparent resin plate of high rigidity may be used instead of combining the quartz glass 40 and the transparent plate 50.

The same effects will be obtained by using a quartz glass 40 that has been coated with a transparent resin film, such as a fluororesin or silicon resin, on the side that comes into contact with the first thermoplastic resin substrate 10.

Also, in the above, the transparent plate 50 having an irregular surface was disposed on the side that comes into contact with the first thermoplastic resin substrate 10, but the transparent plate 50 may instead be provided to a contact face between the second thermoplastic resin substrate 20 and the pressing apparatus, or may be provided to both.

There are no restrictions on the size of the irregularities of the transparent plate 50 and the size of the irregularities of the first thermoplastic resin substrate 10, so long as the transparent plate 50 and the first thermoplastic resin substrate 10 do not stick together by suction.

### Industrial Applicability

The present invention can be used to prevent the destruction or deformation of substrates by heat in thermoplastic resin substrates that have been bonded together. Thus, the present invention can be applied to bio-chips and micro chemical chips in which a channel, reagent reservoir, or the like has been formed in a substrate in order to measure DNA, enzymes, proteins, antigens, antibodies, viruses, cells, and other such biological and chemical substances.

## Claims

1. A method for bonding a first substrate and a second substrate, comprising the steps of:
forming the main body of at least one of the first substrate and the second substrate from an optically transmissive material that transmits light;
forming at least part of the bonding faces of the first substrate and the second substrate from a thermoplastic resin that contains an optically absorbent substance that absorbs light; and
bonding the first substrate and the second substrate together by irradiating the optically absorbent substance of the bonding faces with light via the substrate that transmits light.

2. The bonding method according to Claim 1, wherein a detection substance for detecting a substance to be measured is disposed on the first substrate and/or the second substrate, and the wavelength of the light is between 400 nm and 2.5 µm.

3. The bonding method according to Claim 1, wherein a mask for blocking the light is disposed on a portion corresponding to a place on the first substrate and/or second substrate where the detection substance is fixed, or to a place on the first substrate and/or second substrate where a pattern is formed, and the optically absorbent substance on the bonding faces is irradiated with light from above the mask.

4. The bonding method according to Claim 3, wherein the first substrate and the second substrate are thermoplastic resin substrates, and the melting points of the first substrate and the second substrate are substantially the same.

5. A method for forming a chip, which is formed by bonding a first substrate and a second substrate, said method comprising the steps of:
forming the main body of at least one of the first substrate and the second substrate from an optically transmissive material that transmits light;
forming at least part of the bonding faces of the first substrate and the second substrate from a thermoplastic resin that contains an optically absorbent substance that absorbs light;
forming a channel in a main face of the first substrate and/or the second substrate; and
bonding the first substrate and the second substrate together by positioning the first substrate and the second substrate across from each other so as to cover the channel, and irradiating the optically absorbent substance of the bonding faces with light via the substrate that transmits light.

6. The method for forming a chip according to Claim 5, wherein carbon black is used as the optically absorbent substance, and the layer containing the carbon black has a carbon black content of at least 0.01 vol% and not more than 0.025 vol%.

7. The method for forming a chip according to Claim 6, wherein the layer containing the carbon black is formed by injection molding.

8. The method for forming a chip according to Claim 5, wherein, in the step of bonding the first substrate and the second substrate,
the first substrate and the second substrate are bonded together by subjecting a main face of at least one of the first substrate and the second substrate other than the bonding faces to pressure from a transparent glass sheet via a transparent plate having an irregular surface.

9. The method for forming a chip according to Claim 8, wherein the main face other than the bonding faces that comes into contact with the transparent plate is treated with a solvent.

10. The method for forming a chip according to Claim 5, wherein, in the step of bonding the first substrate and the second substrate,
the first substrate and the second substrate are bonded together by subjecting a main face of at least one of the first substrate and the second substrate other than the bonding faces to pressure from a transparent glass sheet, and
a transparent resin film is formed on a main face of the transparent glass sheet in contact with the main face other than the bonding faces.

11. The method for forming a chip according to Claim 10, wherein the main face other than the bonding faces in contact with the transparent resin film of the transparent glass sheet is treated with a solvent.

12. A chip, including:
a first substrate formed from a thermoplastic resin;
a second substrate opposed and bonded to the first substrate; and
a channel formed on a main face of the first substrate and/or the second substrate,
wherein the main body of at least one of the first substrate and the second substrate is an optically transmissive material that transmits light,
at least part of the bonding faces of the first substrate and the second substrate include an optically absorbent substance that absorbs light, and
the bonding face of the first substrate or the second substrate, which are across from each other so as to cover the channel, are bonded together by irradiating the optically absorbent substance of the bonding faces with light via the substrate that transmits light.

13. The chip according to Claim 12, wherein a detection substance for detecting a substance to be measured is fixed in the channel.

14. The chip according to Claim 13, wherein the detection substance is fixed at least 100 µm away from the location where the optically absorbent substance is introduced.

15. The chip according to Claim 12, wherein the optically absorbent substance is a colorant.

16. The chip according to Claim 12, wherein the optically absorbent substance is a colorant having a different color for each substance to be measured.

17. The chip according to Claim 12, wherein carbon black is used as the optically absorbent substance, and a layer containing the carbon black has a carbon black content of at least 0.01 vol% and not more than 0.025 vol%.

18. The chip according to Claim 17, wherein the layer containing the carbon black is formed by injection molding.
